# EUROPEAN PATENT SPECIFICATION

(11) **EP 0 379 346 B1**
(45) Date of publication and mention of the grant of the patent: **05.10.1994**
(21) Application number: 90300466.1
(22) Date of filing: 17.01.1990
(51) Int. Cl.: H02M 7/5387, H03K 17/08, H01L 25/18

(54) **Power conversion unit and module for its construction**
Energieumwandlungseinheit und Modul für ihren Aufbau
Unité de conversion de puissance et module pour sa construction

(30) Priority: 17.01.1989 JP 8311/89; 19.07.1989 JP 186969/89; 02.10.1989 JP 257294/89
(43) Date of publication of application: 25.07.1990
(73) Proprietor: FUJI ELECTRIC CO. LTD., Kawasaki 210 (JP)
(72) Inventor: Hiroshi, Miki, Hino-shi, Tokyo (JP); Yoshitaka, Fujiwara, Koube-shi, Tokyo (JP); Kiyoshi, Iida, Matumoto-shi, Tokyo (JP); Hiromu, Takubo, Mitaka-shi, Tokyo (JP); Kunio, Shibayama, Koube-shi, Tokyo (JP); Shinichi, Kobayashi, Matumoto-shi, Tokyo (JP)
(74) Representative: Bridge-Butler, Alan James

(56) References cited:
- WO-A-88/09085
- GB-A- 1 178 029
- IEEE TRANSACTIONS ON INDUSTRIAL ELECTRONICS. vol. IE-33, no. 2, 31 May 1986, NEW YORK US pages 185 - 192; K. S. RAJASHEKARA et al.: "Protection and switching-aid networks for transistor bridge inverters"

## Description

The present invention relates to a power conversion unit employing a snubber circuit and to a module for use in making such a unit.

It is well known that a pair of power switching transistors, for example, can be connected in series as self turn-off semiconductor power elements. This series arrangement is connected between the positive and negative poles of a DC power supply to realize power conversion by repeating a cycle of alternate ON and OFF states of each of the power transistors. For three-phase conversion, three series-connected pairs of such power transistors can be connected in parallel with a DC power supply. Examples of the prior art and embodiments of the present invention will be described below in relation to conversion of DC power from this DC power supply to 3-phase AC power by means of a 3-phase inverter.

In a voltage-source 3-phase inverter formed by power transistors, each power transistor is connected in anti-parallel with a free-wheeling diode. Here, when a surge voltage, generated by stray inductance in a circuit while the power transistor is turned OFF (or in the reverse-bias recovery time of the free-wheeling diode), the power transistor in question may be damaged. Moreover, if the rate of increase (dV/dt) of the collector to emitter voltage of such power transistor is large while the power transistor is turned OFF, the other power transistor or control circuit may malfunction.

Accordingly, a snubber circuit is incorporated in the 3-phase inverter in order to avoid such malfunction.

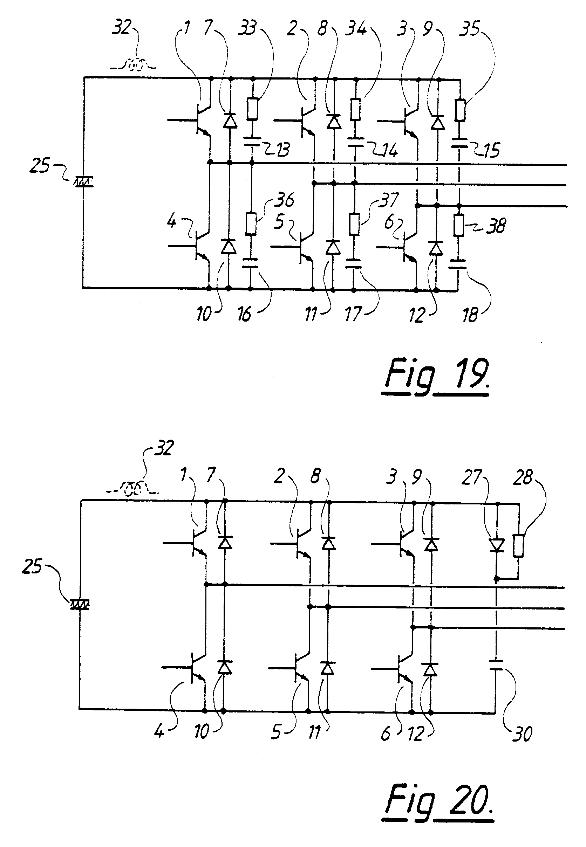

Figure 19 is a circuit diagram of a first prior art form of power conversion unit employing a snubber circuit.

Referring to Figure 19, the unit comprises six power transistors 1 to 6 and six free-wheeling diodes 7 to 12. Each of these six power transistors is connected in anti-parallel with, to form a 3-phase bridge with, the free-wheeling diodes and each power transistor is connected in parallel with a snubber circuit formed by a series connected arrangement of a capacitor 13 to 18 and a resistor 33 to 38. The unit includes a DC power supply 25 and stray inductance 32.

Such a snubber circuit formed by resistors and capacitors is generally called an R-C snubber circuit and the capacitors forming such R-C snubber circuit suppress surge voltages generated when the power transistor connected to this R-C snubber circuit turns OFF and also suppress dV/dt of the collector to emitter voltage of this power transistor through charging of these capacitors and it is effective to give a small resistance value to the resistors forming the R-C snubber circuit in order to improve the suppression of dV/dt.

Figure 20 is a circuit diagram of a second prior art form of power conversion unit employing a snubber circuit.

Referring to Figure 20, the components 1 to 6, 7 to 12, 25 and 32 are the same as in the unit shown in Figure 19 and have the same function as those shown in Figure 19.

In the second prior art circuit shown in Figure 20, a snubber circuit (generally called an R-C-D snubber circuit) formed by resistor 28, capacitor 30 and diode 27 is connected between the positive and negative poles of the DC power supply 25. The capacitor 30 absorbs the energy accumulated in the stray inductance 32 of the circuit when the power transistor turns OFF to suppress the surge voltage. Here, when the resistor 28 and diode 27 of the snubber circuit are removed, the surge voltage suppression effect can be improved.

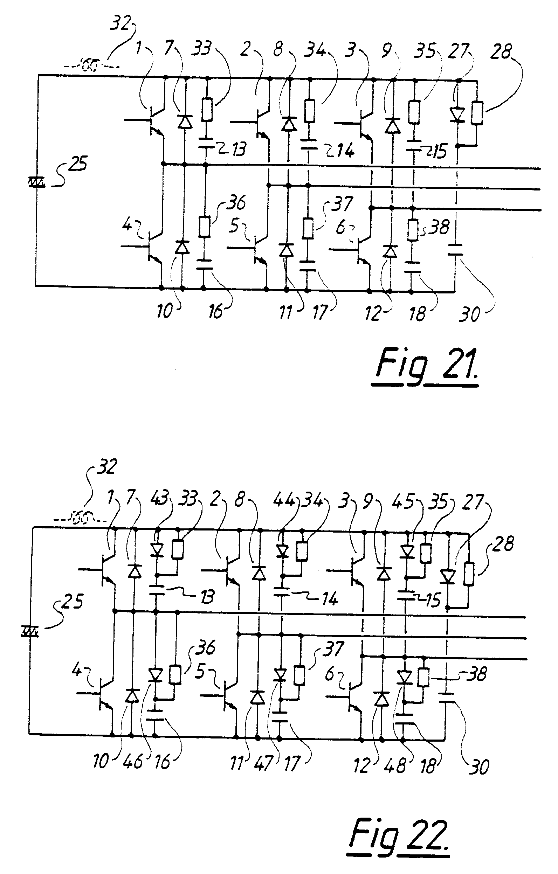

Figure 21 is a circuit diagram of a third prior art form of power conversion unit employing a snubber circuit.

Referring to Figure 21, in the unit shown, the first prior art circuit shown in Figure 19 has been combined with the second prior art circuit shown in Figure 20. The six transistors forming a 3-phase inverter are respectively connected in parallel with individual R-C snubber circuits and also connected with an R-C-D snubber circuit across the positive and negative poles of the power supply.

Figure 22 is a circuit diagram of a fourth prior art form of power conversion unit employing a snubber circuit. Here six transistors 1 to 6 form a 3-phase inverter, as in the circuit shown in Figure 21, except in that they are respectively connected in parallel with individual R-C-D snubber circuits (employing additional diodes 43 to 48) and the R-C-D snubber circuit 27-28-30 is still connected across the positive and negative poles of the power supply.

Snubber circuits of these types are described in 'Protection Techniques of Bipolar Power Transistors' by Masami Ichijo and Hisao Shigekane, published in Fuji Electric Journal, Volume 60, number 10, pages 728 to 733 (1987)

In the prior art circuits described above, if the diode and/or resistor connected in series with the capacitor forming the snubber circuit is/are removed to leave a snubber circuit comprising only the capacitor then, when the power transistor turns OFF, a resonance phenomenon is generated by the capacitor and the stray inductance 32 of circuit. Since this phenomenon causes inconvenience such as generation of noise and increase of duty of power transistor, a resistor must be connected in series with the capacitor from the necessity of suppressing the resonance.

The R-C snubber circuits or R-C-D snubber circuits described above have various disadvantages as described below.

In the R-C-D snubber circuits the disadvantages are:-
1. the resistor has to be large in size to enable the charges in the capacitor to be discharged through the resistor;
2. the control circuit may malfunction due to a high dV/dt generated when the diode of the snubber circuit recovers under reverse bias; and
3. the number of components has increased undesirably because the snubber circuit is complicated in structure.

In the R-C snubber circuit the disadvantages are:-
1. energy loss becomes large since the capacitor is charged or discharged through the resistor; and
2. the resistor has to be large in size.

In addition, these snubber circuits provide the further disadvantages that each connection of the elements forming the snubber circuits to respective semiconductor power conversion elements not only results in troublesome work in the connecting procedures but also causes a large wiring inductance between the semiconductor power conversion element and the snubber circuit and/or a large wiring inductance between the semiconductor power conversion elements, and also results in an increase in the number of components of the snubber circuits and obstruction of management procedures and reduction in size of unit.

UK Patent 1,178,029 relates to the protection of a power driver from inductive loads by the use of a Zener diode with a Zener voltage greater than the supply voltage to absorb energy as the power driver switches to the off state.

In IEEE Transactions on Industrial Electronics, volume IE-33, number 2, 31st May 1986, pages 185 to 192, the protection of power transistors against short circuits is addressed by using an auto-protection drive circuit. A snubber circuit wherein a diode and capacitor are connected in parallel with a power transistor, with a resistor in parallel with the diode, is shown as a switching aid network effective at turn-off of the transistor.

It is therefore an object of the present invention to realize reduction in the number of components and in energy loss through provision of a simplified structure of the snubber circuit connected to the semiconductor power conversion element and also a reduction in size of the power conversion unit using such a snubber circuit and a reduction in wiring inductance through integration of the semiconductor power conversion element and snubber circuit.

According to this invention there is provided a power-conversion unit with a snubber circuit and comprising a plurality of semiconductor power switching elements connected across means for supplying electric power, the snubber circuit comprising at least one series-connected arrangement of an asymmetrical voltage element having different voltage drops in respective opposite directions of conduction, the invention being characterised by a capacitor connected in series with each said semiconductor power switching element and in parallel with each semiconductor power switching element, or a capacitor connected in series with the asymmetric voltage element across said power supply means, and by the asymmetric voltage element having a breakdown voltage in the reverse direction lower than the power supply voltage.

Preferably said asymmetrical voltage element comprises a Zener diode. In a particular embodiment, said asymmetrical voltage element is a semiconductor element, said unit comprising a semiconductor power switching element connected to a semiconductor asymmetrical voltage element, a conductive base to which is secured an electrically insulating substrate, a conductive pattern being formed on the substrate and having conductive electrical connection to one side of the main current path of the power switching element and to the same polarity side of the asymmetrical voltage element, the other side of the asymmetrical voltage element being connected to a first electrode mounted on the substrate and insulated from the conductive pattern, the other side of the main current path of the power switching element being connected to a second electrode mounted on the substrate and insulated from the conductive pattern, a capacitor of the snubber circuit being connected between the first and second electrodes.

It may be provided that said power-switching element and said asymmetrical voltage element are hermetically sealed in a synthetic resin moulding whose surface carries terminals of the semiconductor components for external connection, the moulding being shaped to accommodate said capacitor such that the moulding and capacitor combination does not project beyond a flat connection surface of the module carrying terminals for external connection to an adjacent module.

It may be that the moulding has a corner cut-away portion for accommodating the capacitor adjacent terminals for connection to the capacitor.

Alternatively the moulding may have a central recess between power supply terminals for the power switching element, said central recess serving to accommodate said capacitor.

Embodiments of this invention will now be described, by way of example, with reference to the accompanying drawings, in which:-
Figure 1 is a circuit diagram of part of a power conversion unit employing a snubber circuit in a first embodiment of the present invention;
Figure 2 is a circuit diagram of a sub-unit comprising one of the semiconductor power conversion elements together with one arm of a snubber circuit shown in Figure 1;
Figure 3 and Figure 4 are waveform diagrams illustrating the operation of the sub-unit in Figure 2;
Figure 5 is a circuit diagram of part of a power conversion unit employing a snubber circuit in a second embodiment of the present invention;
Figure 6 is a circuit diagram of a single phase section of the unit shown in Figure 5;
Figure 7 is a circuit diagram of part of a power conversion unit employing a snubber circuit in a third embodiment of the present invention;
Figure 8 is a representative circuit diagram of a single phase section of the unit shown in Figure 7;
Figure 9 is a circuit diagram of part of a power conversion unit employing a snubber circuit in a fourth embodiment of the present invention;
Figure 10 is a perspective view of the structure of a sub-unit module used in constructing a unit as shown in Figure 1;
Figure 11 is a circuit diagram of a sub-unit module formed only using semiconductor elements;
Figure 12 is a perspective external view of a first form of the sub-unit module shown in Figure 11 constructed using conventional technology;
Figures 13a and 13b are plan and side views in an assembly diagram for a single phase section of a power conversion unit using the sub-unit module shown in Figure 12;
Figure 14 is a perspective external view of a second form of sub-unit module embodying the present invention;
Figures 15a and 15b are plan and side views in an assembly diagram for a single phase section of a power conversion unit using the sub-unit module shown in Figure 14;
Figure 16 is a perspective external view of a third form of sub-unit module embodying the present invention;
Figure 17 is a circuit diagram of a single phase inverter embodying the present invention;
Figure 18 is an assembly diagram for the single phase inverter shown in Figure 17 using sub-unit modules each as shown in Figure 16; and
Figures 19 to 22 are respective circuit diagrams of first to fourth prior art forms of power conversion unit each employing a snubber circuit.

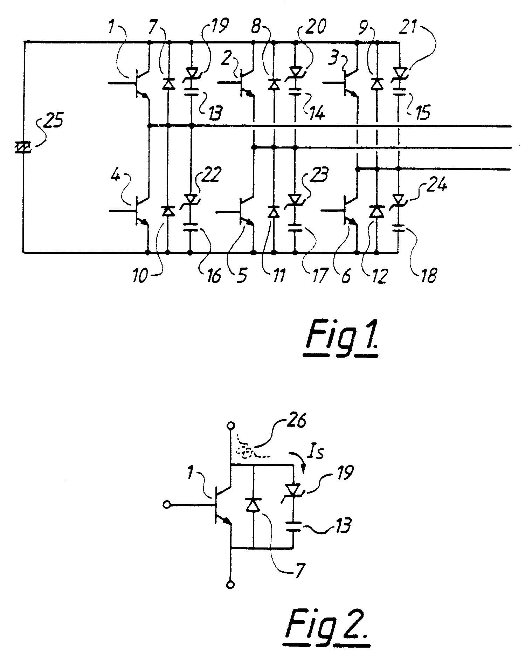

Referring to Figure 1, the power conversion unit shown has six power transistors 1 to 6 acting as self turn-off semiconductor power elements, six free-wheeling diodes 7 to 12 and a DC power supply 25 similar to those shown in Figure 19.

However, in this first embodiment, the power conversion unit includes a snubber circuit comprising six reference Zener diodes 19 to 24 respectively in series with six capacitors 13 to 18, each series-connected set of Zener diode and capacitor being connected in parallel with a respective one of the six power transistors 1 to 6.

Figure 2 is a circuit diagram of a sub-unit of the unit shown in Figure 1 and comprising a semiconductor power conversion element 1,7 in parallel with one arm 13,19 of the snubber circuit.

In the circuit shown in Figure 2, a series circuit of the reference Zener diode 19 acting as a voltage drop asymmetrical element and the capacitor 13 is connected to the power transistor 1 and free-wheeling diode 7. In this case the Zener voltage of the diode 19 is set to a value lower than the voltage of DC power supply 25.

A surge voltage generated when the power transistor 1 turns OFF is absorbed by the capacitor 13 through the Zener diode 19. When the capacitance of capacitor 13 is assumed as C and the current flowing through the capacitor 13 as Iₛ, since the voltage drop across the Zener diode 19 due to the current Iₛ can be neglected, the value of dV/dt applied to the power transistor 1 becomes Iₛ/C and so dV/dt can be suppressed so that the load on the power transistor 1 during turn-OFF can be alleviated.

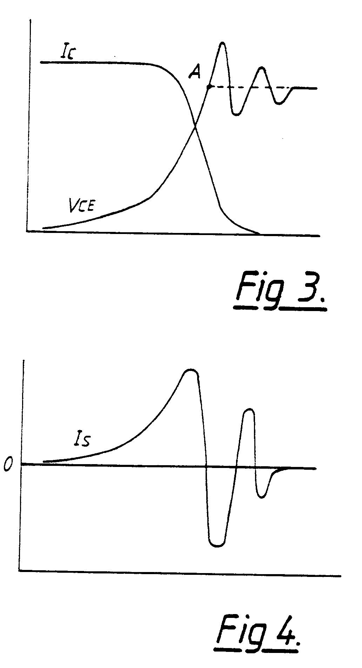

Figure 3 and Figure 4 are waveforms illustrating the operation of the sub-unit shown in Figure 2. Figure 3 relates to the collector current I_{c} of the power transistor 1 and to the collector-to-emitter voltage V_{CE} and Figure 4 to the current Iₛ flowing into the capacitor 13.

Referring to Figures 3 and 4, when the power transistor 1 turns OFF and the collector-to emitter voltage V_{CE} rises to the voltage value of the DC power source 25 (point A in Figure 3), resonance with the capacitor 13 starts with a current flowing due to the stray inductance 26 of the circuit so that a resonance current flows into the snubber circuit. For the polarity of resonance current where the Zener voltage of the Zener diode 19 is generated, this diode 19 consumes energy so that the resonance phenomenon can be damped within a comparatively short period. As a result, the duty of the capacitor 13 can be reduced.

The energy loss provided by means of the diode 19 is converted to heat and since the diode 19 is a semiconductor, it can be cooled more easily than a resistor.

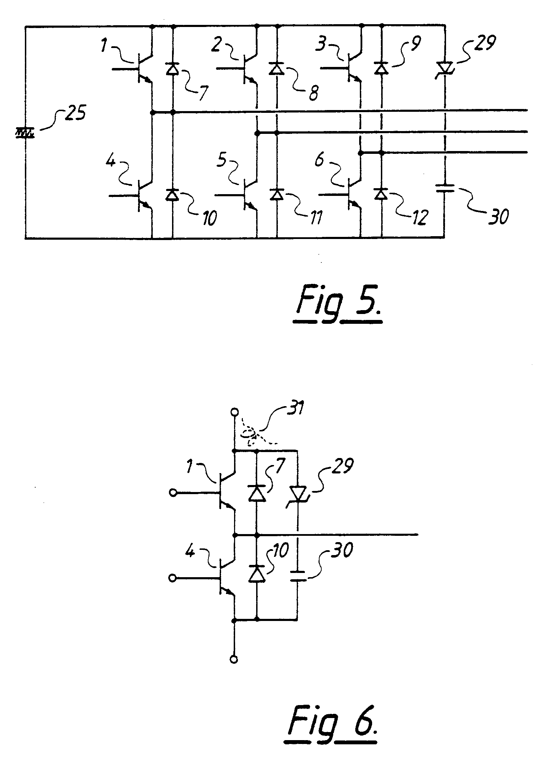

In Figure 5 there is shown a second embodiment of power conversion unit in which a series-connected arrangement of Zener diode 29 as asymmetrical voltage element and capacitor 30 is connected between the positive and negative poles of a 3-phase inverter formed by six power transistors 1 to 6 and six free-wheeling diodes 7 to 12. The Zener voltage of the Zener diode 29 is set to a value lower than the voltage value of DC power supply 25.

Figure 6 is a circuit diagram of a single phase section of the power conversion unit shown in Figure 5 comprising semiconductor power conversion elements 1,7 and 4,10 and snubber circuit 29,30.

Since the snubber circuit formed by the series-connected Zener diode 29 and capacitor 30 is connected between the external terminals of a series-connected arrangement of the power transistors 1 and 4, an increasing rate of collector-to-emitter voltage cannot be suppressed unlike the first embodiment described above but a surge voltage generated when the power transistor 1 or 4 turns OFF may be absorbed by the Zener diode 29 through the capacitor 30. Therefore the power transistor which turns OFF can be protected from breakdown due to the surge voltage.

Like the first embodiment, the snubber circuit of the second embodiment gives rise to a resonance phenomenon due to stray inductance 31 and capacitor 30 but such a resonance phenomenon can also be damped within a comparatively short period as with the first embodiment due to the effect of the Zener diode 29.

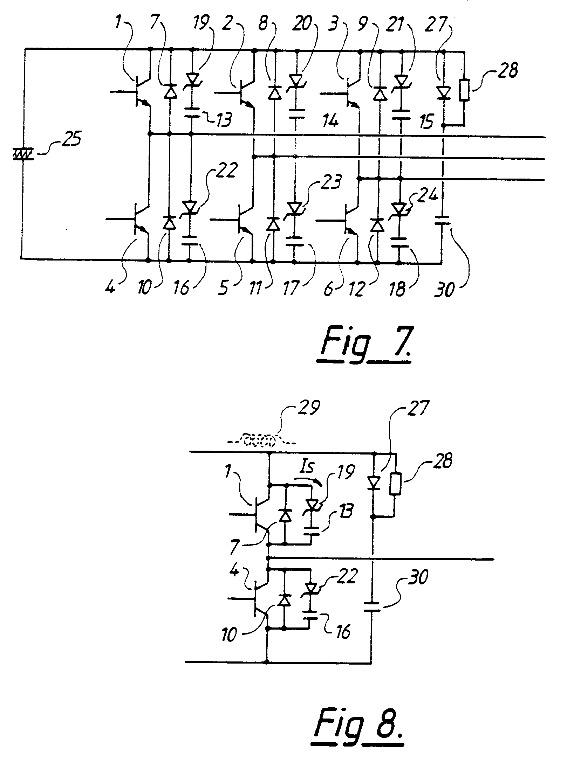

Referring to Figure 7, as in the first embodiment, a series arrangement of Zener diode and capacitor is connected in parallel,with each sub-unit of the 3-phase inverter formed by the six power transistors 1 to 6 and six free-wheeling diodes 7 to 12 and an R-C-D snubber circuit formed by diode 27, resistor 28 and capacitor 30 is connected between the positive and negative poles of the power supply.

In Figure 8, the operation of the snubber circuit formed by the Zener diode-capacitor arrangements respectively connected in parallel with the power transistors 1 and 4 are same as for the first embodiment shown in Figure 1.

For example, when the power transistor 1 turns OFF and its collector-to-emitter voltage rises to exceed the voltage of the DC power supply 25, the R-C-D snubber circuit formed by the diode 27, resistor 28 and capacitor 30 protects the power transistor 1 from breakdown through the operation that the diode 27 turns ON and the capacitor 30 absorbs the surge voltage generated by the stray inductance 29.

Moreover, since the excessive charge generated by the surge voltage and accumulated in the capacitor 30 after the power transistor 1 turns OFF, is discharged through the resistor 28, the resonance of the capacitor 30 and stray inductance 29 can be prevented by selecting an appropriate resistance value of the resistor 28.

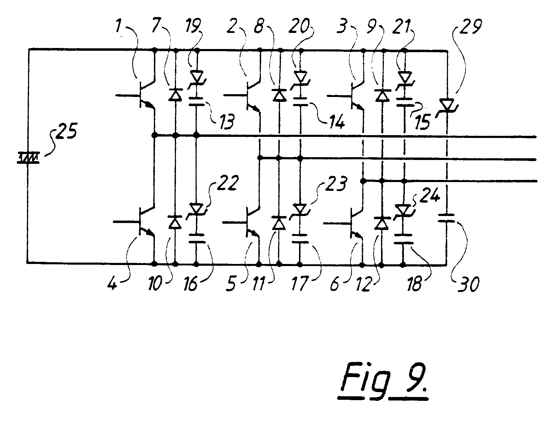

Referring to Figure 9, the power conversion unit shown in the fourth embodiment combines the first embodiment shown in Figures 1 and 2 with the second embodiment shown in Figures 5 and 6.

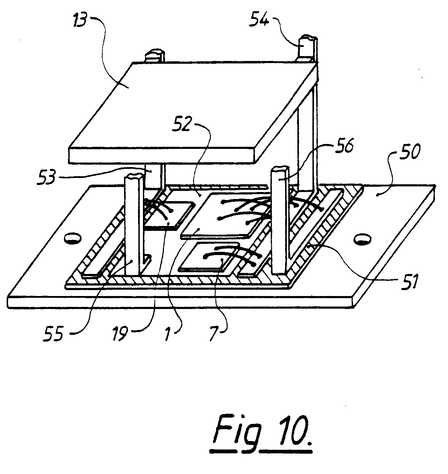

Referring to Figure 10, there is shown an actual construction of the first embodiment of sub-unit module (as shown in Figure 2).

A ceramics substrate 51 which exhibits excellent heat conductivity is bonded as an insulated substrate on to a conductive base in the form of a copper plate 50. A conductive pattern circuit in the form of a copper pattern 52 is machined on the substrate 51 in the desired shape. A first electrode 53, a second electrode 54 and a base terminal 56 are separately secured to the ceramics substrate 51 so that these electrodes are electrically insulated from each other.

Since the collector of the power transistor 1, the cathode of free-wheeling diode 7 and the anode of the Zener diode 19 are intimately attached to the copper pattern 52, these are electrically at the same potential.

With such an arrangement, heat generated by the power transistor 1, free-wheeling diode 7 and Zener diode 19 is transmitted to the copper base 50 through the ceramics substrate 51. Thus, losses generated as heat in these semiconductor elements are quickly and effectively removed by cooling this copper base 50.

Each semiconductor power element, e.g. 1,7,19 described above and its associated capacitor, e.g. 13, can be arranged in three dimensions and the module structure can be made small by connecting one electrode of the capacitor 13 to the first electrode 53, and the other electrode of the capacitor 13 to the second electrode 54 and supporting this capacitor 13 by means of the first and second electrodes 53 and 54.

The circuit of the sub-unit shown in Figure 2 can be completed by connecting, using the wires, between semiconductor elements on the copper pattern 52 and the electrodes and terminals on the ceramics substrate 51, namely between the cathode of the Zener diode 19 and the first electrode 53, between the emitter of the power transistor 1 and the second electrode 54, between the anode of the free-wheeling diode 7 and the second electrode 54 and between the base of the power transistor 1 and the base terminal 56.

This module can be connected externally together with the base terminal 56, by connecting collector terminal 55 on the copper pattern 52 and using the second electrode 54 as the emitter terminal.

In Figure 10, only the module for one sub-unit is shown as being mounted on the copper plate 50 but in practice, the modules for a number of sub-units can of course be mounted on the base plate 50.

In the first embodiment of module as shown in Figure 10, the capacitor 13 of the snubber circuit is included. Since this capacitor 13 is large in comparison with the other components and the components other than this capacitor 13 are all semiconductor components, it is better to form the module only from these semiconductor components from the viewpoint of the cooling process.

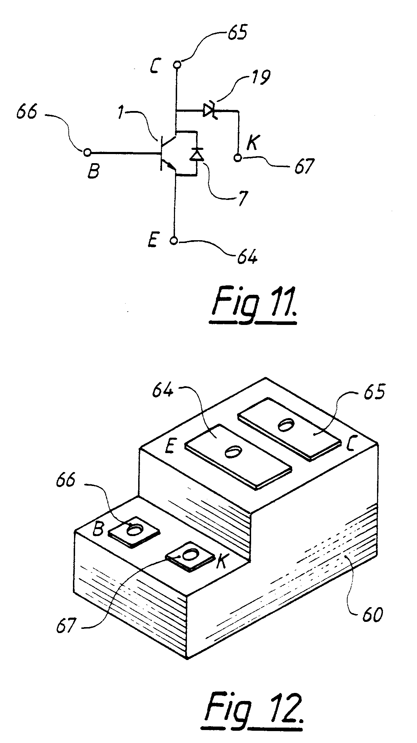

Figure 11 is a circuit diagram of a sub-unit module comprising only semiconductor components, the capacitor 13 having been omitted compared with the circuit shown in Figure 2. In the case of such a circuit structure, emitter terminal 64, collector terminal 65, base terminal 66 and snubber circuit terminal 67 are provided.

In Figure 12, the power transistor 1, free-wheeling diode 7, connected in anti-parallel with this power transistor, and the reference Zener diode 19 having its anode electrode connected to the collector electrode of the power transistor 1 are hermetically sealed in a moulded synthetic resin block to form a module 60. The surface of this module 60 is provided with emitter terminal 64 (E), collector terminal 65 (C), base terminal 66 (B) and snubber circuit terminal 67 (K) for connecting external lines.

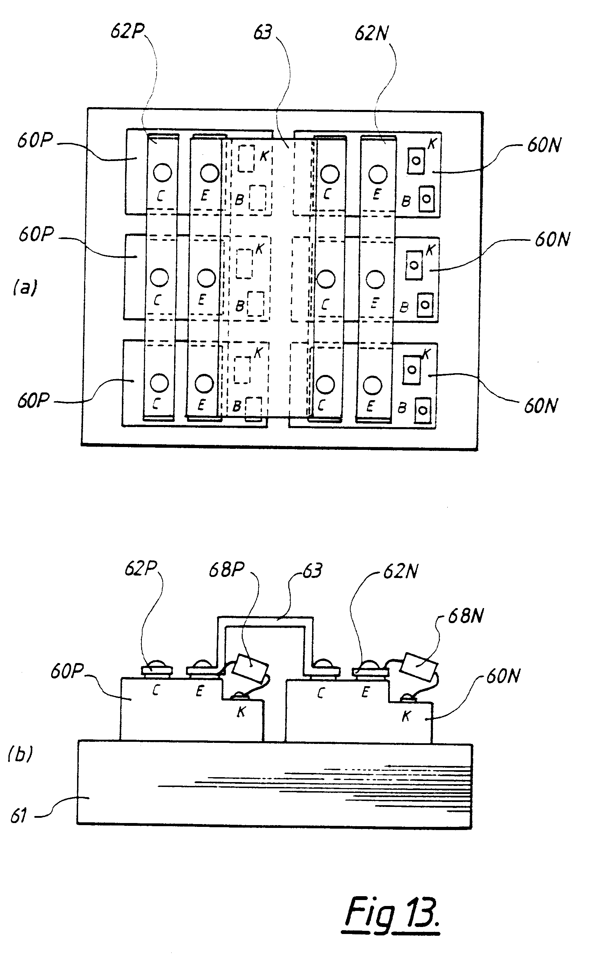

As shown in Figures 13a and 13b, the power conversion unit is formed by mutually connecting the collector terminals of three positive-side modules 60P using a positive-side copper bar 62P and by mutually connecting the emitter terminals of three negative-side modules 60N using negative-side copper bar 62N.

The six modules 60P and 60N are mounted on common cooling body 61 and the emitter terminals of the modules 60P are connected to the respective collector terminal of the modules 60N by means of a copper connecting bar 63. In this case, the copper connecting bar 63 must be formed in a U-shape in order to provide mounting space for each snubber capacitor 68P attached to respective module 60P. The copper connecting bar 63 thus requires excessive material resulting in the disadvantage that not only the size and weight of the unit is increased, but the wiring inductance is also increased.

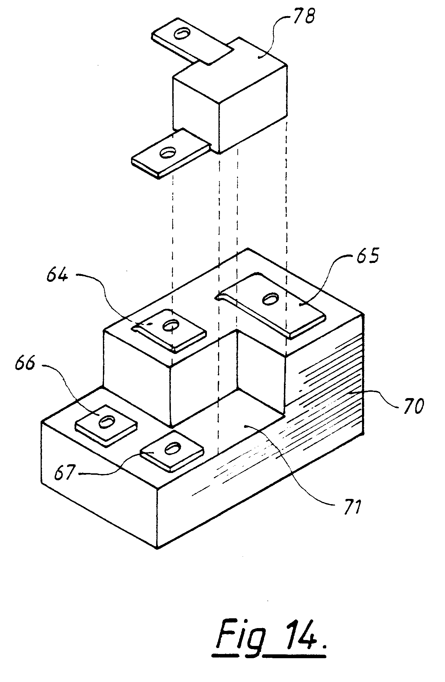

A second construction is shown in Figure 14 in which a module 70 is hermetically sealed by moulding in synthetic resin a sub-unit as shown in Figure 11, namely the circuit formed by the power transistor 1, free-wheeling diode 7 and Zener diode 19. This module 70 is also provided like the module shown in Figure 12 with emitter terminal 64, collector terminal 65, base terminal 66 and snubber circuit terminal 67.

However, in the module 70 shown in Figure 14, a cut-away portion is provided and the snubber capacitor 78 can be accommodated within this cut-away portion 71.

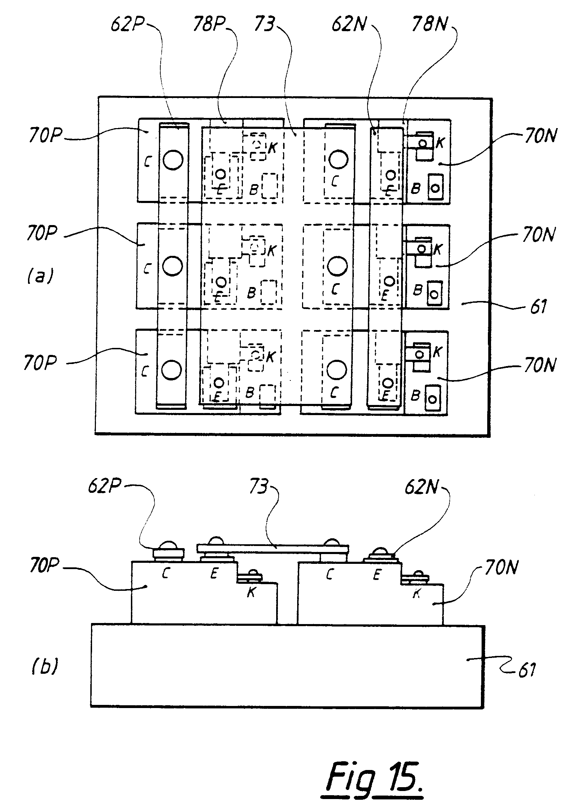

As shown in Figures 15a and 15b, the collector terminals of three positive-side modules 70P are connected together with a positive-side copper bar 62P and the emitter terminals of three negative-side modules 70N are connected together with negative-side copper bar 62N.

These six modules are mounted on the cooling body 61 and the positive-side modules and negative-side modules together in pairs by means of connecting copper bar 73. Since the snubber capacitor 78 is completely accommodated in the cut-away portion 71 provided in the module 70, it is no longer necessary to make the copper connecting bar 73 U-shaped.

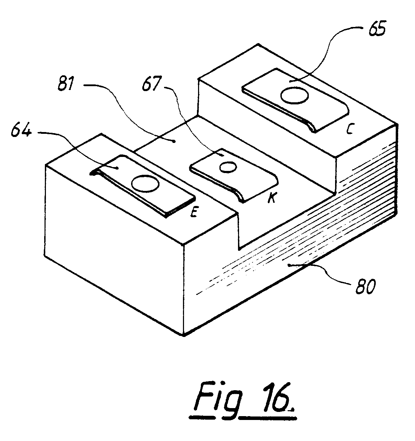

The embodiment shown in Figure 16 again comprises a sub-unit as shown in Figure 11, namely, a circuit formed by the power transistor 1, free-wheeling diode 7 and the Zener diode 19 within a synthetic resin moulding to form module 80 with a rectangular parallelepiped shape. This rectangular parallelepiped module unit 80 has a central recessed portion 81 providing the snubber circuit terminal 67. The emitter terminal 64 and collector terminal 65 are provided on respective sides of the recessed portion 81. (The base terminal is not shown nor described because it is not related necessary for an understanding of this embodiment).

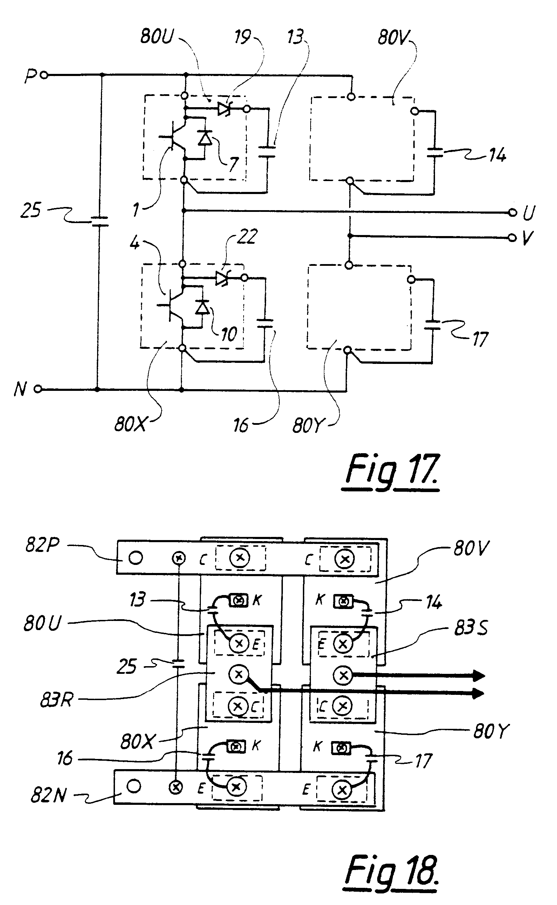

Figure 17 is a circuit diagram of a single phase inverter wherein four modules 80U, 80V, 80X, 80Y, each as shown in Figure 16, are connected by means of single phase bridges and the respective modules are provided with snubber capacitors.

Figure 18 is an assembly diagram of the single phase inverter shown in Figure 17.

As shown in Figure 18, the collector terminals of the two modules 80U and 80V are inter-connected by means of positive-side copper bar 82P and the emitter terminals of the two modules 80X and 80Y are inter-connected by means of negative-side copper bar 82N and connection between the modules 80U and 80X is made by means of copper connecting bar 83R, while connection between the modules 80V and 80Y is made by means of copper connecting bar 83S, to form the single phase inverter.

In this case, since snubber capacitors 13,14,16,17 mounted on the modules are accommodated in the recessed portions 81 of the respective modules, there is no undesirable projection from the single phase inverter and the unit as a whole may be formed small in size.

The embodiments described above use a simple junction power transistor as the basic semiconductor power component but it is obvious that such embodiments may also be applied to the case where the power transistor is replaced with some other self turn-off semiconductor power element, for example, an insulated gate bipolar transistor or field effect transistor.

In the embodiments described above, since resonance currents can quickly be attenuated by means of the snubber circuits, formed by connecting an asymmetrical voltage element such as a Zener diode in series with a capacitor, the capacitance of the capacitors in the snubber circuit can be kept low and energy loss can also be alleviated by omitting the resistor from the snubber circuit. In addition, elimination of the resistor from the snubber circuit provides various beneficial effects such as a reduction in the number of components and simplification and reduction in size of the unit. The sub-unit module can be formed small in size and it may be used as a single unitary component since the semiconductor power element, free-wheeling diode and Zener diode are mounted on the conductive pattern to radiate heat generated in the semiconductor elements to the outside. Thus assembly, wiring and component management procedures are avoided.

Moreover, since a space for accommodating the snubber capacitor is provided in the module as a cut-away portion or as a recess at the time of forming the module in a hermetically sealed moulding, the snubber capacitor does not interfere with the wiring during assembly of the power conversion unit using such modules. Thus straight wiring can be achieved and various beneficial effects such as saving of wiring material, reduction of wiring inductance, reduction in size and weight of the unit can also be attained.

It will be clear that the embodiments described above can be modified in polarities by appropriate selection of and orientation of the various semiconductor components.

## Claims

1. A power-conversion unit with a snubber circuit and comprising a plurality of semiconductor power switching elements (1, 2, 3, 4, 5, 6) connected across means for supplying electric power (25), the snubber circuit comprising at least one series-connected arrangement of an asymmetrical voltage element (19, 20, 21, 22, 23, 24) having different voltage drops in respective opposite directions of conduction, and characterised by comprising a capacitor (13, 14, 15, 16, 17, 18) connected in series with the asymmetrical voltage element (19, 20, 21, 22, 23, 24) and in parallel with each said semiconductor power switching element or a capacitor (30) connected in series with an asymmetric voltage element (29) across said power supplying means (25) and in that the asymmetric voltage element (19, 20, 21, 22, 23, 24) has a breakdown voltage lower than the power supply voltage in the reverse direction.

2. A power conversion unit according to Claim 1, wherein said asymmetrical voltage element (19, 20, 21, 22, 23, 24; 29) comprises a Zener diode.

3. A power conversion unit according to Claim 1 or Claim 2, wherein said asymmetrical voltage element (19, 20, 21, 22, 23, 24; 29) is a semiconductor element, said unit comprising the semiconductor power switching element connected to the semiconductor asymmetrical voltage element, a conductive base (50) to which is secured an electrically insulating substrate (51), a conductive pattern (52) being formed on the substrate (51) and having conductive electrical connection to one side of the main current path of the power switching element (1) and to the same polarity side of the asymmetrical voltage element (19), the other side of the asymmetrical voltage element (19) being connected to a first electrode (53) mounted on the substrate (51) and insulated from the conductive pattern (52), the other side of the main current path of the power switching element being connected to a second electrode (54) mounted on the substrate and insulated from the conductive pattern, a capacitor (13) of the snubber circuit being connected between the first and second electrodes (53, 54).

4. A power conversion unit according to any one of the preceding Claims, wherein said power-switching element (1, 2, 3, 4, 5, 6) and said asymmetrical voltage element (19, 20, 21, 22, 23, 24) are hermetically sealed in a synthetic resin moulding whose surface carries terminals (64, 65, 66, 67) of the semiconductor components for external connection, the moulding being shaped to accommodate said capacitor (78) such that the moulding and capacitor combination does not project beyond a flat connection surface of the module carrying terminals for external connection to an adjacent unit.

5. A power conversion unit according to Claim 4, wherein the moulding has a corner cut-away portion for accommodating the capacitor (78) adjacent terminals (64, 67) for connection to the capacitor.

6. A power conversion unit according to Claim 4, wherein the mould has a central recess (81) between power supply terminals (64, 65) for the power switching element, said central recess (81) serving to accommodate said capacitor.

## Patentansprüche

1. Energieumwandlungseinheit mit einem Dämmungskreis und einer Vielzahl von Halbleiterenergieschaltelementen (1, 2, 3, 4, 5, 6), die über eine Vorrichtung zur Einspeisung elektrischer Energie (25) verbunden sind, wobei der Dämmungskreis zumindest eine seriengeschaltete Anordnung eines asymmetrischen Spannungselements (19, 20, 21, 22, 23, 24) mit verschiedenen Spannungsabfällen in die jeweils entgegengesetzten Leitungsrichtungen aufweist, dadurch gekennzeichnet, daß ein Kondensator (13, 14, 15, 16, 17, 18) mit dem asymmetrischen Spannungselement (19, 20, 21, 22, 23, 24) in Serie und mit jedem Halbleiterenergieschaltelement parallel geschaltet ist oder ein Kondensator (30) mit einem asymmetrischen Spannungselement (29) über die genannte Vorrichtung zur Energieeinspeisung (25) in Serie geschaltet ist und daß das asymmetrische Spannungselement (19, 20, 21, 22, 23, 24) eine Durchbruchsspannung aufweist, die niedriger ist als die Speisespannung in die entgegengesetzte Richtung.

2. Energieumwandlungseinheit nach Anspruch 1, dadurch gekennzeichnet, daß das asymmetrische Spannungselement (19, 20, 21, 22, 23, 24; 29) eine Zenerdiode aufweist.

3. Energieumwandlungseinheit nach Anspruch 1 oder Anspruch 2, dadurch gekennzeichnet, daß das asymmetrische Spannungselement (19, 20, 21, 22, 23, 24; 29) ein Halbleiterelement ist, wobei die genannte Einheit ein Halbleiterenergieschaltelement, das mit dem asymmetrischen Halbleiterspannungselement verbunden ist, eine leitende Platte (50), auf der sich ein Elektroisoliersubstrat (51) befindet, ein auf dem Substrat (51) gebildetes Leiterbild (52) und elektrisch leitende Verbindungen zu einer Seite des Hauptstromweges des Energieschaltelements (1) und zu der gleichen Polaritätsseite des asymmetrischen Spannungselements (19) aufweist, wobei die eine Seite des asymmetrischen Spannungselements (19) mit einer ersten an dem Substrat (51) angebrachten Elektrode (53) verbunden und von dem Leiterbild (52) isoliert ist, die andere Seite des Hauptstromweges des Energieschaltelements mit einer zweiten an dem Substrat angebrachten Elektrode (54) verbunden und von dem Leiterbild isoliert ist und ein Kondensator (13) des Dämmungskreises zwischen der ersten und der zweiten Elektrode (53, 54) angebracht ist.

4. Energieumwandlungseinheit nach einem der obigen Ansprüche, dadurch gekennzeichnet, daß das Energieschaltelement (1, 2, 3, 4, 5, 6) und das asymmetrische Spannungselement (19, 20, 21, 22, 23, 24) hermetisch von einer Kunstharzform umschlossen sind, deren Oberfläche mit Anschlußpunkten (64, 65, 66, 67) der Halbleiterteile für externen Anschluß versehen ist, wobei die Form den Kondensator (78) derart aufnimmt, daß die Form und der Kondensator zusammen nicht über eine ebene Anschlußfläche des mit Anschlußpunkten für den externen Anschluß an Nebeneinheiten versehenen Moduls hinausragen.

5. Energieumwandlungseinheit nach Anspruch 4, dadurch gekennzeichnet, daß die Form einen Eckenabschnitt zur Aufnahme der Nebenanschlußpunkte (64, 67) des Kondensators (78) zur Verbindung mit dem Kondensator aufweist.

6. Energieumwandlungseinheit nach Anspruch 4, dadurch gekennzeichnet, daß die Form eine Mittelvertiefüng (81) zwischen den Energieeinspeisungsanschlußpunkten (64, 65) für das Energieschaltelement aufweist, wobei die Mittelvertiefüng (81) zur Aufnahme des Kondensators dient.

## Revendications

1. Unité de conversion de puissance avec un circuit amortisseur et comprenant une pluralité d'éléments de commutation (1, 2, 3, 4, 5, 6) de puissance à semi-conducteurs aux bornes d'un moyen d'alimentation électrique (25), le circuit d'amortissement comprenant au moins un montage en série d'un élément (19, 20, 21, 22, 23, 24) à tension asymétrique ayant des chutes de tension différentes dans les sens respectifs opposés de conduction, et caractérisée en ce qu'elle comprend un condensateur (13, 14, 15, 16, 17, 18) en série avec l'élément (19, 20, 21, 22, 23, 24) à tension asymétrique et en parallèle avec chacun desdits éléments de commutation de puissance à semiconducteurs, ou un condensateur (30) en série avec un élément (29) à tension asymétrique aux bornes dudit moyen d'alimentation électrique (25) et en ce que l'élément (19, 20, 21, 22, 23, 24) à tension asymétrique a une tension de claquage inférieure à la tension d'alimentation électrique dans le sens opposé.

2. Unité de conversion de puissance selon la revendication 1, dans laquelle ledit élément (19, 20, 21, 22, 23, 24; 29) à tension asymétrique comprend une diode Zener.

3. Unité de conversion de puissance selon la revendication 1 ou la revendication 2, dans laquelle ledit élément (19, 20, 21, 22, 23, 24; 29) à tension asymétrique est un élément à semi-conducteurs, ladite unité comprenant l'élément de commutation de puissance à semiconducteurs relié à l'élément à tension asymétrique à semi-conducteurs, une base conductrice (50) à laquelle est fixé un substrat électriquement isolant (51), un motif conducteur (52) étant formé sur le substrat (51) et ayant une connexion électrique conductrice avec un côté du trajet principal de courant de l'élément de commutation (1) de puissance et avec le côté de même polarité de l'élément (19) à tension asymétrique, l'autre côté de l'élément (19) à tension asymétrique étant relié à une première électrode (53) montée sur le substrat (51) et isolée du motif conducteur (52), l'autre côté du trajet principal de courant de l'élément de commutation de puissance étant relié à une seconde électrode (54) montée sur le substrat et isolée du motif conducteur, un condensateur (13) du circuit amortisseur étant monté entre la première et la seconde électrodes (53, 54).

4. Unité de conversion de puissance selon l'une quelconque des revendications précédentes, dans lequel ledit élément de commutation (1, 2, 3, 4, 5, 6) de puissance et ledit élément (19, 20, 21, 22, 23, 24) à tension asymétrique sont hermétiquement enfermés dans un moulage en résine synthétique dont la surface porte les bornes (64, 65, 66, 67) des composants à semi-conducteurs pour les connexions extérieures, le moulage ayant une forme permettant de loger ledit condensateur (78) de façon que la combinaison constituée par le moulage et le condensateur ne dépasse pas d'une surface de connexion plane du module portant des bornes pour la connexion extérieure à une unité contiguë.

5. Unité de conversion de puissance selon la revendication 4, dans laquelle le moulage a un angle abattu pour recevoir le condensateur (78) au voisinage immédiat des bornes (64, 67) pour la connexion au condensateur.

6. Unité de conversion de puissance selon la revendication 4, dans laquelle le moulage a un évidement central (81) entre des bornes d'alimentation (64, 65) pour l'élément de commutation de puissance, ledit évidement central (81) servant à recevoir ledit condensateur.
